# EUROPEAN PATENT SPECIFICATION

(11) **EP 4 498 047 B1**
(45) Date of publication and mention of the grant of the patent: **05.11.2025**
(21) Application number: 23188120.2
(22) Date of filing: 27.07.2023
(51) Int. Cl.: G01H 1/00, G01R 31/327, H01H 9/00

(54) **A COMPUTER-IMPLEMENTED METHOD FOR MONITORING AN ELECTRICAL SWITCHING COMPONENT IMMERSED IN A LIQUID**
COMPUTERIMPLEMENTIERTES VERFAHREN ZUR ÜBERWACHUNG EINER IN EINE FLÜSSIGKEIT EINGETAUCHTEN ELEKTRISCHEN SCHALTKOMPONENTE
PROCÉDÉ MIS EN UVRE PAR ORDINATEUR POUR SURVEILLER UN COMPOSANT DE COMMUTATION ÉLECTRIQUE IMMERGÉ DANS UN LIQUIDE

(43) Date of publication of application: 29.01.2025
(73) Proprietor: Hitachi Energy Ltd, 8050 Zürich (CH)
(72) Inventor: ABEYWICKRAMA, Nilanga, 723 51 Västerås (SE); SCHIESSLING, Joachim, 749 42 Enköping (SE); FORSSEN, Cecilia, 724 60 Västerås (SE)
(74) Representative: Valea AB

(56) References cited:
- PENGJU KANG ET AL: "Condition Assessment of Power Transformer Onload Tap Changers Using Wavelet Analysis and Self-Organizing Map: Field Evaluation", IEEE TRANSACTIONS ON POWER DELIVERY, IEEE SERVICE CENTER, NEW YORK, NY, US, vol. 18, no. 1, 1 January 2003 (2003-01-01), XP011078918, ISSN: 0885-8977
- SEO JUNHYUCK ET AL: "On Savitzky-Golay Filtering for Online Condition Monitoring of Transformer On-Load Tap Changer", IEEE TRANSACTIONS ON POWER DELIVERY, IEEE SERVICE CENTER, NEW YORK, NY, US, vol. 33, no. 4, 1 August 2018 (2018-08-01), pages 1689 - 1698, XP011683174, ISSN: 0885-8977, [retrieved on 20180509], DOI: 10.1109/TPWRD.2017.2749374
- VIERECK K ET AL: "Driving Reliability with Machine Learning and Improving Operation by Digitalization of Power Transformers", 2019 IEEE PES GTD GRAND INTERNATIONAL CONFERENCE AND EXPOSITION ASIA (GTD ASIA), IEEE, 19 March 2019 (2019-03-19), pages 217 - 222, XP033551275, DOI: 10.1109/GTDASIA.2019.8715987

## Description

### TECHNICAL FIELD

The present invention relates to automated monitoring of an electrical switching component immersed in a liquid in a container of an electrical device comprising a transformer or an on-load tap changer (OLTC).

### BACKGROUND OF THE INVENTION

On-load tap changers (OLTCs) are used with power transformers and regulate their voltage under load, i.e., without interrupting the power supply to consumers.

On load tap changers are by far the most contributor to the major transformer failures worldwide and therefore deserve condition-based maintenance assisted by online monitoring. Switching time (total and partial) of the operation sequence of a tap changer is one of the most important parameters that can be associated with various health issues inside a tap changer. A normal switching time of the OLTC can be measured at production of the OLTC or established using historical measurement in use, as further elaborated below. In use, the actual switching time can be measured by methods like pressure pulse analysis or vibration signal analysis. By monitoring the switching time, i.e. the measured switching time in use, and comparing it to the normal switching time, a deviation time may be determined to be the difference between the actual switching time and the normal switching time. If the deviation time is too large, there is probably something wrong with the OLTC, and action should be taken, such as scheduling maintenance work.

Accordingly, the deviation time, or any other measurable deviation, may be monitored and compared to a predetermined deviation criterion, such as a predetermined time or a predetermined percentage of the normal switching time. One can monitor the total switching time and/or one can monitor partial switching time, i.e. the time it takes to complete sub-portions of a switching sequence.

Such monitoring may alternatively be performed on other electrical switching components than electrical switching components of OLTC:s. Accordingly, a transformer or an on-load tap changer (OLTC) may be provided with an electrical switching component immersed in a liquid in a container. The electrical switching component may be a tap changer or some other switching device. The switching component comprises movable mechanical components, such as one or more electrical contact elements. When the mechanical components move and/or make contact, vibrations form around the switching component. For a fully functional switch, the vibrations emitted at each movement of a switching sequence follows a specific pattern governed by the design of the switching component, and external factors, such ambient temperature. In other words, the vibration pattern is predictable for a fully functional electrical switching component.

By studying the vibrations emitted during operation of the switching component, one or more deviations from the specific pattern may be detected. A certain amount of deviation is normal but abnormal deviations are typically associated with some malfunction or wear of the electrical switching component.

The environment in use around a switching component may present various sources of vibrations making it difficult to study the vibrations emitted by the switching component, and hence more difficult to monitor the function of the electrical switching component using vibration analysis.

PENGJU KANG ET AL: "Condition Assessment of Power Transformer Onload Tap Changers Using Wavelet Analysis and Self-Organizing Map: Field Evaluation" XP011078918, ISSN: 0885-8977, discloses a condition monitoring system for common types of OLTCs aimed at enabling a condition of tap changer contacts and an associated drive system to be inferred from vibration signals.

SEO JUNHYUCK ET AL: "On Savitzky-Golay Filtering for Online Condition Monitoring of Transformer On-Load Tap Changer", XP011683174, ISSN: 0885-8977, DOI: 10.1109/TPWRD.2017.2749374, discusses how vibro-acoustic measurement on a transformer's onload tap changer (OLTC) can provide indications on its mechanical Condition. Specifically, a joint vibro-acoustic and arcing measurement system is discussed, which uses correlation the vibro-acoustic signal to mechanical events of OLTC's operation.

VIERECK K ET AL: "Driving Reliability with Machine Learning and Improving Operation by Digitalization of Power Transformers", XP033551275, DOI: 10.1109/GTDASIA 2019.8715987 discusses a method for analysis, visualization and interpretation of vibroacoustic of online measurements of on-load tap-changers.

### SUMMARY OF THE INVENTION

An object of the invention is to provide a robust method for monitoring an electrical switching component immersed in a liquid in a container. A further object is to enable robust monitoring of both total switching time and partial switching time, i.e. the time it takes to perform a full switching sequence, and one or more sub-portions of the switching sequence.

According to a first aspect, this and other objects are achieved by a computer-implemented method according to claim 1 with alternative embodiments presented in the dependent claims.

The computer-implemented method is suitable for monitoring an electrical switching component immersed in a liquid in a container of an electrical device comprising a transformer or an on-load tap changer (OLTC). The method comprises, by a processing circuitry of a computer system:
obtaining a vibration signature model defining at least a vibration signature associated with movement of one or more mechanical components of the electrical switching component during a switching sequence of the electrical switching component from one switching position to another switching position of the electrical switching component,
obtaining a vibration signal recording from a vibration sensor configured to measure vibrations of the container,
determining a first smoothed curve based on the vibration signal recording using a first smoothing level,
determining a second smoothed curve based on the vibration signal recording using a second smoothing level lower than the first smoothing level,
selecting a portion in time of the second smoothed curve based on an extent in time of a peak of the first smoothed curve,
comparing one or more peaks of the selected portion the second smoothed curve to one or more peaks of a corresponding portion of the vibration signature to determine one or more deviations based on the comparison,
determining a deviation status based on the deviations, and
providing a deviation status signal based on the deviation status.

The vibration signature model is typically pre-determined in a lab using measurements on a fully functional electrical switching device. Alternatively, the vibration signature model could be determined using machine-learning on a fully functional electrical switching device.

The claimed computer-implemented method comprises obtaining the vibration signal model and is not limited to how the vibration signature model as such is determined.

The vibration signal is obtained and then used to compare make a comparison between information derivable from the vibration signal recording and a vibration signature of the vibration signature model.

Two curves with different smoothing levels are derived from the vibration signal recording. The first smoothed curve with a higher smoothing level, i.e. less detailed curve, is used to identify different sub-portions of the switching sequence by selecting an extent in time based on the curvature of a peak of the first smoothed curve, and then the second smoothed curve, which is more detailed than the first smoothed curve, is studied.

Specifically, only the selected extent in time of the second smoothed curve is studied and peaks of the second smoothed curve outside the selected extent in time are not included in the comparison of the sub-portion of the switching sequence compares to the corresponding sub-portion of the switching sequence of the signature model. This approach improves the method's ability to correctly match information derivable from the vibration signal recording to corresponding information of the vibration signature since a bigger picture is established first, using the first smoothed curve, thus absorbing influence from noise or abnormal data such as missing peaks or additional peaks of the vibration signal recording. Thus, the risk of comparing one or more specific peaks of the more detailed curve to wrong peak(s) of the vibration signature model decreases.

It should be understood that correct comparison between a vibration signal recording from a fully functional electrical switching component to the vibration signature is less prone to go wrong than a comparison between the vibration signal recording of a non-functional electrical switching component and the vibration signature. The above-described computer-implemented method increases accuracy of said comparison and increases the ability of the model to identify deviations for sub-portions of a switching sequence.

In the drawings, the peaks of the first smoothed curve are referred to as global peaks and the peaks of the second smoothed curve are referred to as local peaks.

The use of a lower smoothing level means that more details of the vibration signal recording remain in the smoothed curve than would have been the case when using a higher smoothing level.

The selection of an extent in time of a peak of the first smoothed curve may be performed in any suitable way. For example, the extent in time of a peak of the first smoothed curve may be from a start time of the peak of the first smoothed curve to a start time of a subsequent peak or, if no subsequent peak is present in the first smoothed curve, to the end of the first smoothed curve, or to a time being offset a predetermined time after the start time of the last peak of the first smoothed curve.

The start time may be determined to be the time when the first smoothed curve reaches a minimum absolute value between the peak and a preceding peak of the first smoothed curve, or reaches a predetermined threshold level, whichever occurs closer in time to the time of a maximum absolute value of the peak.

The example curves illustrated in the figures are derived such that they measure strength of vibration as a one-sided curve on a positive side of the Y-axis of the graph, i.e. with positive values. Alternatively, the curves could be derived such that they are one-sided on the negative side of the Y-axis, such that the signal strength is measured in negative terms. To cover both these approaches, the method looks at the absolute value of the vibration strength indicated by the respective curve.

Said comparing of one or more peaks of the selected portion the second smoothed curve to one or more peaks of a corresponding portion of the vibration signature may comprise comparing a maximum absolute value and/or a duration of one or more peaks of the selected portion of the second smoothed curve to a maximum absolute value and/or duration of one or more corresponding peaks of a corresponding portion of the vibration signature.

Any suitable implantation of the signature model may be used and preferably enables identification of a peak of the second smoothed curve using at least information from the first smoothed curve, such as information pertaining to which peak of the first smooth curve a peak of the second smoothed curve belongs to. This enables classification of the peaks of the second smoothed curve for improved identification of which portion of the switching sequence the specific peak of the second smoothed curve belongs to.

Deviations may be studied in terms of extent of time of one or more peaks of the second smoothed curve, and/or in terms of maximum absolute value of a specific peak of the second smoothed curve. Hence, a specific peak may be studied, or a group of peaks may be jointly studied to a reference peak or group of peaks. For example, a total switching time may be studied for a group of all peaks of the second smoothed curve. The switching time model may comprise information for discarding initial peaks of the first or second smoothed curves not of interest for monitoring purposes.

The duration may be calculated as the extent in time from a start time of a peak of the second smoothed curve to a start time of a subsequent peak of the second smoothed curve, or, if no subsequent peak is present in the second smoothed curve, to the end of the second smoothed curve, or to a time being offset a predetermined time after the start time of the peak.

The deviation status may be determined to be a normal status in response to said deviation being within a predetermined deviation range or below a predetermined deviation threshold, and/or the deviation status may be determined to be an error status in response to said deviation being outside said predetermined deviation range or exceeding said predetermined deviation threshold.

Accordingly, the monitoring may be based on continuously providing/receiving an OK status, such that an omission of provision of said OK status indirectly means that something is not OK with the electrical switching component. Alternatively, or additionally, the monitoring may be based on providing a status indicating something is not OK when such status is determined, wherein the existence of the provision of such a status means that something is not OK with the electrical switching component.

A low-pass filter may be applied to the vibration signal when determining the first and second smoothed curves. The low-pass filter may have a cut-off frequency of 0.5 - 1 kHz.

The first smoothed curve may be determined using a root mean square smoothing with a moving time window in the range of 5-10 milliseconds.

The second smooth curve may be determined using a root mean square smoothing with a moving time window smaller than the moving time window used for determining the first smoothed curve.

According to a second aspect, the object is also achieved by an electrical device according to claim 11, with alternative embodiments presented in the dependent claims. The electrical device comprises a transformer or an on-load tap changer (OLTC), and: a container, an electrical switching component immersed in a liquid in the container, a vibration sensor configured to measure vibrations of the container, and a computer system comprising a processing circuitry configured to perform the computer-implemented method described above.

### BRIEF DESCRIPTION OF DRAWINGS

The appended figures are schematic representations of non-limiting embodiments.
Fig. 1 shows an example of an electrical device 10 in the form of a transformer assembly 10 provided with an on-load tap changer 12.
Fig. 2 shows an example of a graphical plot of a vibration recording.
Fig. 3 shows the first C1 and second C2 smoothed curves, and maximum absolute values marked for the peaks of the first C1 and second C2 smoothed curves.
Fig. 5 shows a graphical plot of the second smoothed curve, along with some of the time portions selected using information from the peaks of the first smoothed curve. Here it is possible to see which peaks of the second smoothed curve are associated with the switching sub-sequence indicated by a respective peak of the first smoothed curve.
Fig. 6 shows a schematic overview of the method steps of the computer-implemented method for monitoring an electrical switching component immersed in a liquid in a container of an electric device.
Fig. 7 shows a schematic overview of the computer system implementing the monitoring method.

### DETAILED DESCRIPTION

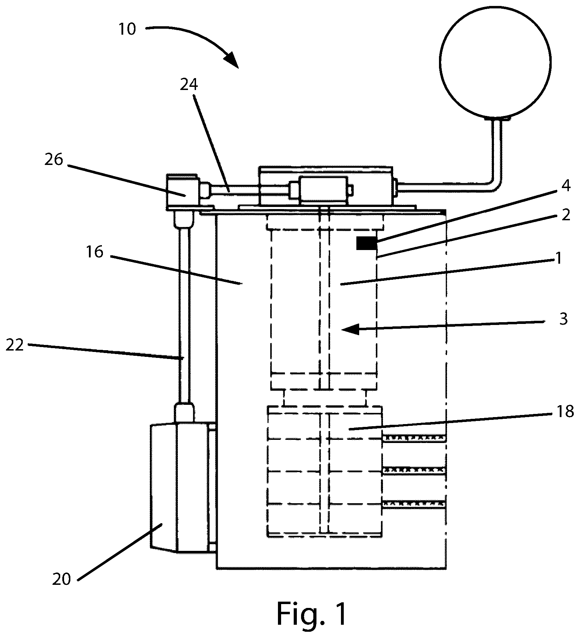

Fig. 1 shows an example of an electrical device 10 in the form of a transformer assembly 10 provided with an on-load tap changer 12. The on-load tap changer 12 comprises an electrical switching component 1 in the form of a diverter switch.

The on-load tap changer 12 comprises two separate sections. The two separate sections are the diverter switch 1, which generally may be in its own housing separate from the transformer housing 16, and a tap selector 18. The tap selector 18, which is mounted beneath the diverter switch 1, consists of a fine tap selector and usually a change-over selector. In the example illustrated in Figure 1, there are two diverter switches 1 and three tap selectors.

Power to operate the tap-changer 12 is supplied from the motor drive mechanism 20, which is typically mounted on the outside of the transformer 10. The power is transmitted by means of shafts 22, 24, and bevel gears 26, which turn the tap selector 18 from tap to tap.

Electrical switching components of the diverter switch 1 are immersed in a liquid in a container 2. The transformer assembly 10 is provided with a vibration sensor 4 configured to measure vibrations of the container 2. Also, a computer system 700 is provided, said computer system 700 comprising a processing circuitry 702 configured to perform a computer-implemented method M for monitoring of the electrical switching component 1. In other embodiments any other electrical switching component 1 immersed in a liquid in a container 2 could alternatively be monitored.

Embodiments of the computer-implemented method will hereinafter be described with reference to the appended figures.

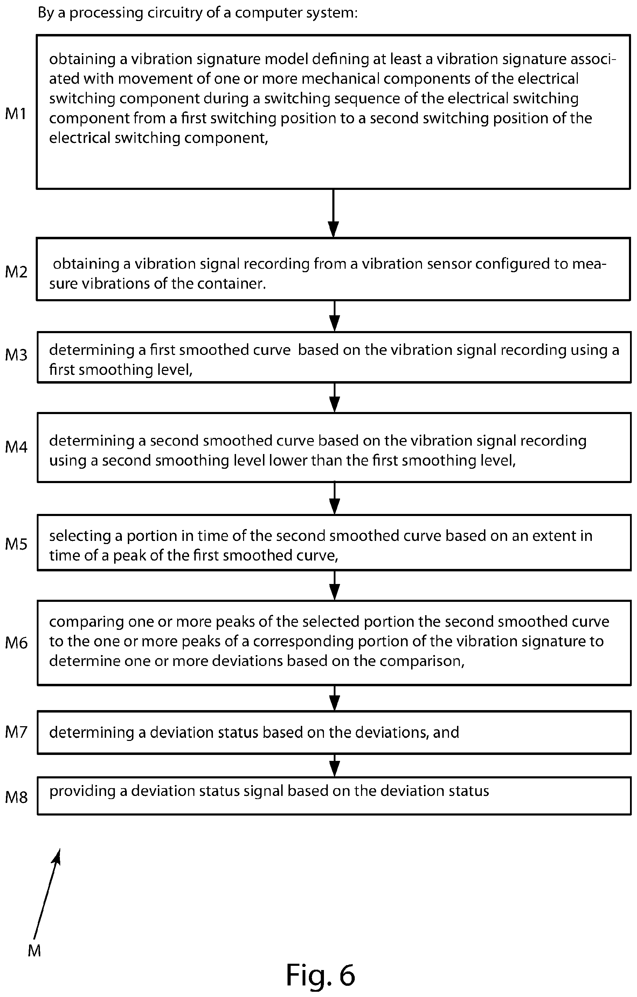

The computer-implemented method M is suitable for monitoring an electrical switching component 1 immersed in a liquid in a container 2 of an electrical device comprising a transformer or an on-load tap changer (OLTC) 3. As shown in fig. 6, the method M comprises at least, by a processing circuitry 4 of a computer system 5:
obtaining M1 a vibration signature model defining at least a vibration signature associated with movement of one or more mechanical components of the electrical switching component 1 during a switching sequence of the electrical switching component 1 from a one switching position to another switching position of the electrical switching component,
obtaining M2 a vibration signal recording R from a vibration sensor 4 configured to measure vibrations of the container 2,
determining M3 a first smoothed curve C1 based on the vibration signal recording R using a first smoothing level,
determining M4 a second smoothed curve C2 based on the vibration signal recording R using a second smoothing level lower than the first smoothing level,
selecting M5 a portion in time of the second smoothed curve C2 based on an extent in time of a peak P1 of the first smoothed curve C1,
comparing M6) one or more peaks P2) of the selected portion the second smoothed curve C2) to one or more peaks of a corresponding portion of the vibration signature to determine one or more deviations based on the comparison,
determining M7) a deviation status based on the deviations, and
providing M8) a deviation status signal based on the deviation status.

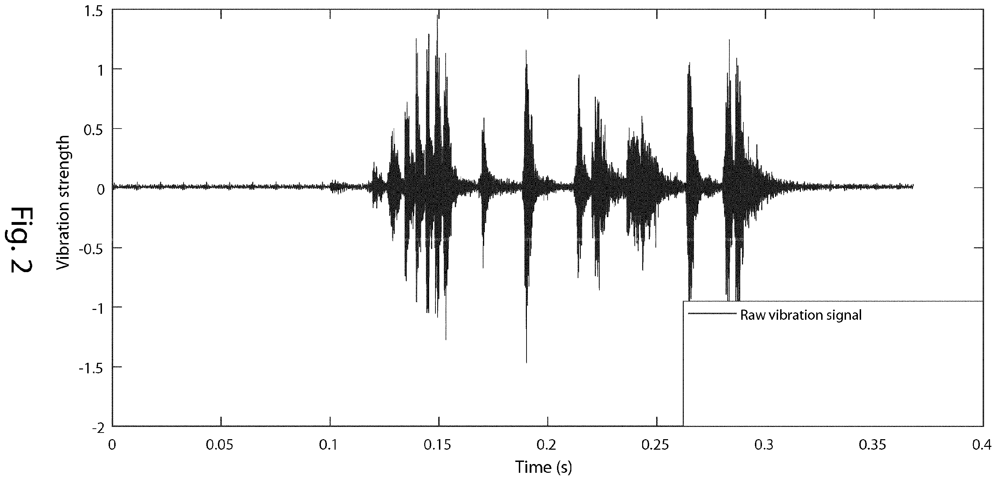

Fig. 2 shows an example of a graphical plot of a vibration signal recording.

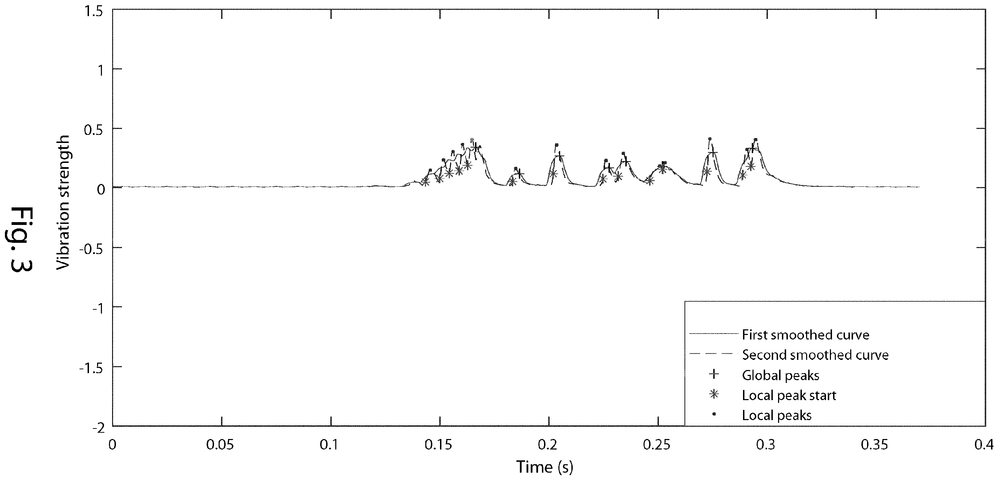

Fig. 3 shows the first C1 and second C2 smoothed curves, and maximum absolute values marked for the peaks of the first C1 and second C2 smoothed curves. The envelope for both curves C1, C2 are derived such that the curves are one-sided using Hilbert transform or any other suitable method. Also, fig. 3 shows markings for start times of the peaks of the second smoothed curve C2. It is evident that the lower level of smoothing of the second smoothed curve provides a curve with more details than the first smoothed curve C1.

Any suitable level of smoothing may be applied when determining the first C1 and second C2 smoothed curves. In the present example, smoothing has been made using root mean square smoothing with a moving time window of 6 ms for the first smoothed curve C1, and a moving window of 1 ms for the second smoothed curve C2. In other embodiments, other values for the moving window may alternatively be used instead, as long as the second smoothed curve C2 is determined using a root mean square smoothing with a moving time window smaller than the moving time window used for determining the first smoothed curve C1. Typically, the first smoothed curve C1 is determined using a root mean square smoothing with a moving time window in the range of 5-10 ms.

The extent in time of a peak may be chosen according to any suitable method, as long as the same method is used both when deriving the vibration signature and when comparing the vibration recording against the signature model.

In the present embodiment, the first smoothed curve C1 is from a start time of the peak P1 of the first smoothed curve C1 to a start time of a subsequent peak or, if no subsequent peak is present in the first smoothed curve C1, to the end of the first smoothed curve C1, or to a time being offset a predetermined time after the start time of the last peak P1 of the first smoothed curve C1.

Also the start time may be chosen according to any suitable method, as long as the same method is used both when deriving the vibration signature and when comparing the vibration recording against the signature model.

In the present embodiment, the start time is determined to be the time when the first smoothed curve C1 reaches a minimum absolute value between the peak P1 and a preceding peak of the first smoothed curve C1, or reaches a predetermined threshold level L, whichever occurs closer in time to the time of a maximum absolute value of the peak.

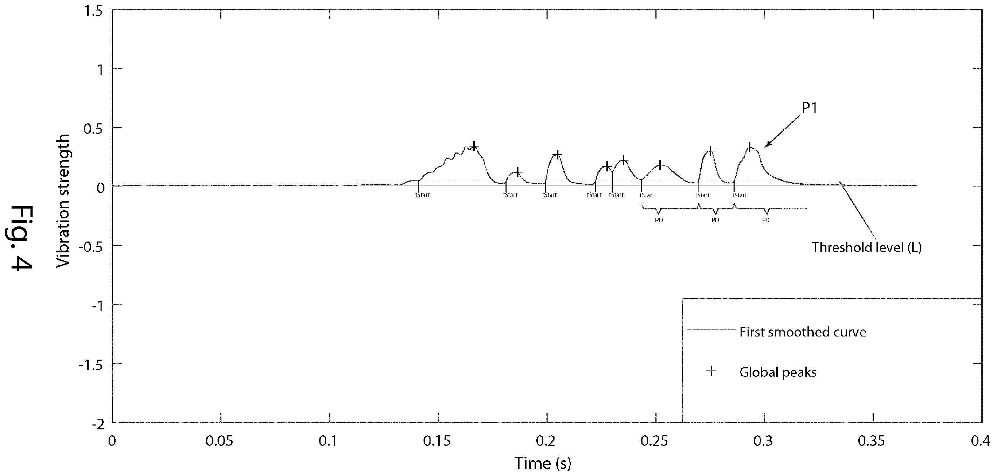

Fig. 4 shows a graphical plot of the first smoothed curve, along with indications under the horizontal axis indicating some of the extents in time determined using information from the peaks of the first smoothed curve.

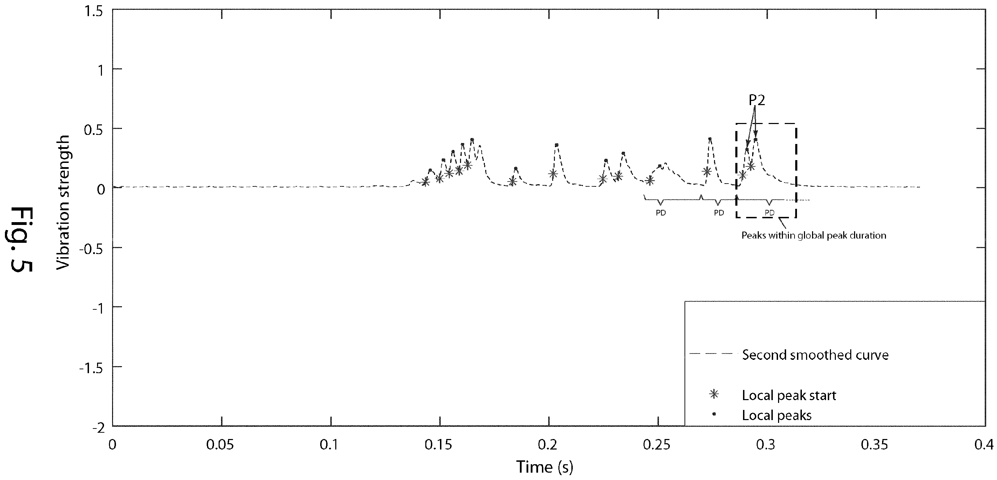

Fig. 5 shows a graphical plot of the second smoothed curve, along with some of the time portions selected using the extents in time identified with information from the peaks of the first smoothed curve. Here it is possible to see which peaks of the second smoothed curve are associated with the switching sub-sequence indicated by a respective peak of the first smoothed curve.

In this embodiment, the comparing of one or more peaks of the selected portion the second smoothed curve C2 to the one or more peaks of a corresponding portion of the vibration signature comprises comparing a maximum absolute value and/or a duration of one or more peaks of the selected portion of the second smoothed curve C2 to a maximum absolute value and/or duration of one or more corresponding peaks of a corresponding portion of the vibration signature. In other embodiments, any other suitable method for achieving the comparison may alternatively be used instead.

The duration of a peak P2 of the second smoothed curve C2 may be calculated as the extent in time from a start time of a peak P2 of the second smoothed curve C2 to a start time of a subsequent peak of the second smoothed curve C2, or, if no subsequent peak is present in the second smoothed curve C2, to the end of the second smoothed curve C2, or to a time being offset a predetermined time after the start time of the peak P2.

The start time of a peak P2 of the second smoothed curve C2 may be determined using any suitable method. In the present embodiment, the start time of a peak P2 of the second smoothed curve C2 is determined to be the time when the second smoothed curve C1 reaches a predetermined threshold level which is a threshold level defined by the vibration signature for each peak P2. In other embodiments, the start of the peak P2 may be found using a threshold level proportional to the maximum absolute value of the respective peak P2, or it may be the time when the curve reaches a minimum absolute value between the peak P2 and a preceding peak of the second smoothed curve C2.

The deviation status may be determined to be a normal status in response to said deviation being within a predetermined deviation range or below a predetermined deviation threshold, and/or the deviation status is determined to be an error status in response to said deviation being outside said predetermined deviation range or exceeding said predetermined deviation threshold.

In this embodiment, a low-pass filter is applied to the vibration signal when determining the first and second smoothed curves. The low-pass filter has a cut-off frequency of 0.5 - 1 kHz but may alternatively be configured with any other suitable cut-off frequency.

In other embodiments, noise may alternatively be handled using any other suitable method, or not handled at all.

As indicated above, the method M is used on an electrical device 10 comprising a transformer or an on-load tap changer OLTC 3. The electrical device 10 comprises a container 2 which may be a part of the transformer or part of the on-load tap changer, or which may be a container separate from the transformer or the OLTC. In this embodiment, the container is part of the OLTC. The electrical device 10 further comprises an electrical switching component 1 immersed in a liquid in the container 2, a vibration sensor 4 configured to measure vibrations of the container 2, and a computer system 700 comprising a processing circuitry 702 configured to perform the above-described computer-implemented method M. In this embodiment, the vibration sensor 4 is attached to the container 2 but in other embodiments it may be attached anywhere it is able to sense vibrations associated with the movements of the mechanical members of the switching component 1. The sensor 4 may be any suitable type of vibration sensor. For example, the vibration sensor may be an optical sensor configured to measure vibration of the container 2 using light reflected by the container 2 to the optical sensor.

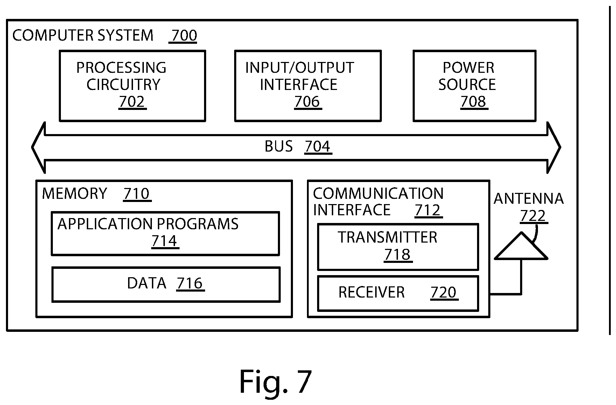

Figure 7 shows a computer system 700 in accordance with some embodiments. As used herein, a computer system 700 refers to a device or system capable, configured, arranged and/or operable to communicate with network nodes and/or other computer systems. Examples of a computer system include, but are not limited to, a smart phone, mobile phone, cell phone, desktop computer, personal digital assistant (PDA), wearable terminal device, wireless endpoint, tablet, laptop, laptop-embedded equipment (LEE), laptop-mounted equipment (LME), smart device, wireless customer-premise equipment (CPE), etc.

A computer system may support device-to-device (D2D) communication, for example by implementing a electrical switching 3GPP standard for sidelink communication, Dedicated Short-Range Communication (DSRC), vehicle-to-vehicle (V2V), vehicle-to-infrastructure (V2I), or vehicle-to-everything (V2X).

The computer system 700 includes processing circuitry 702, also referred to herein as a processor device, that is operatively coupled via a bus 704 to an input/output interface 706, a power source 708, a memory 710, a communication interface 712, and/or any other component, or any combination thereof. Certain computer systems may utilize all or a subset of the components shown in Figure 7. The level of integration between the components may vary from one computer system to another computer system. Further, certain computer systems may contain multiple instances of a component, such as multiple processors, memories, transceivers, transmitters, receivers, etc.

The processing circuitry 702 is configured to process instructions and data and may be configured to implement any sequential state machine operative to execute instructions stored as machine-readable computer programs in the memory 710. The processing circuitry 702 may be implemented as one or more hardware-implemented state machines (e.g., in discrete logic, field-programmable gate arrays (FPGAs), application specific integrated circuits (ASICs), etc.); programmable logic together with appropriate firmware; one or more stored computer programs, general-purpose processors, such as a microprocessor or digital signal processor (DSP), together with appropriate software; or any combination of the above. For example, the processing circuitry 702 may include multiple central processing units (CPUs).

In the example, the input/output interface 706 may be configured to provide an interface or interfaces to an input device, output device, or one or more input and/or output devices. Examples of an output device include a speaker, a sound card, a video card, a display, a monitor, a printer, an actuator, an emitter, a smartcard, another output device, or any combination thereof. An input device may allow a user to capture information into the computer system 700. Examples of an input device include a touch-sensitive or presence-sensitive display, a camera (e.g., a digital camera, a digital video camera, a web camera, etc.), a microphone, a sensor, a mouse, a trackball, a directional pad, a trackpad, a scroll wheel, a smartcard, and the like. The presence-sensitive display may include a capacitive or resistive touch sensor to sense input from a user. A sensor may be, for instance, an accelerometer, a gyroscope, a tilt sensor, a force sensor, a magnetometer, an optical sensor, a proximity sensor, a biometric sensor, etc., or any combination thereof. An output device may use the same type of interface port as an input device. For example, a Universal Serial Bus (USB) port may be used to provide an input device and an output device.

In some embodiments, the power source 708 is structured as a battery or battery pack. Other types of power sources, such as an external power source (e.g., an electricity outlet), photovoltaic device, or power cell, may be used. The power source 708 may further include power circuitry for delivering power from the power source 708 itself, and/or an external power source, to the various parts of the computer system 700 via input circuitry or an interface such as an electrical power cable. Delivering power may be, for example, for charging of the power source 708. Power circuitry may perform any formatting, converting, or other modification to the power from the power source 708 to make the power suitable for the respective components of the computer system 700 to which power is supplied.

The memory 710 may be or be configured to include memory such as random access memory (RAM), read-only memory (ROM), programmable read-only memory (PROM), erasable programmable read-only memory (EPROM), electrically erasable programmable read-only memory (EEPROM), magnetic disks, optical disks, hard disks, removable cartridges, flash drives, and so forth. In one example, the memory 710 includes one or more application programs 714, such as an operating system, web browser application, a widget, gadget engine, or other application, and corresponding data 716. The memory 710 may store, for use by the computer system 700, any of a variety of various operating systems or combinations of operating systems.

The memory 710 may be configured to include a number of physical drive units, such as redundant array of independent disks (RAID), flash memory, USB flash drive, external hard disk drive, thumb drive, pen drive, key drive, high-density digital versatile disc (HD-DVD) optical disc drive, internal hard disk drive, Blu-Ray optical disc drive, holographic digital data storage (HDDS) optical disc drive, external mini-dual in-line memory module (DIMM), synchronous dynamic random access memory (SDRAM), external micro-DIMM SDRAM, smartcard memory such as tamper resistant module in the form of a universal integrated circuit card (UICC) including one or more subscriber identity modules (SIMs), such as a USIM and/or ISIM, other memory, or any combination thereof. The UICC may for example be an embedded UICC (eUICC), integrated UICC (iUICC) or a removable UICC commonly known as 'SIM card.' The memory 710 may allow the computer system 700 to access instructions, application programs and the like, stored on transitory or non-transitory memory media, to off-load data, or to upload data. An article of manufacture, such as one utilizing a communication system may be tangibly embodied as or in the memory 710, which may be or comprise a device-readable storage medium.

The processing circuitry 702 may be configured to communicate with an access network or other network using the communication interface 712. The communication interface 712 may comprise one or more communication subsystems and may include or be communicatively coupled to an antenna 722. The communication interface 712 may include one or more transceivers used to communicate, such as by communicating with one or more remote transceivers of another device capable of wireless communication (e.g., another computer system or a network node in an access network). Each transceiver may include a transmitter 718 and/or a receiver 720 appropriate to provide network communications (e.g., optical, electrical, frequency allocations, and so forth). Moreover, the transmitter 718 and receiver 720 may be coupled to one or more antennas (e.g., antenna 722) and may share circuit components, software or firmware, or alternatively be implemented separately.

In the illustrated embodiment, communication functions of the communication interface 712 may include cellular communication, Wi-Fi communication, LPWAN communication, data communication, voice communication, multimedia communication, short-range communications such as Bluetooth, near-field communication, location-based communication such as the use of the global positioning system (GPS) to determine a location, another like communication function, or any combination thereof. Communications may be implemented in according to one or more communication protocols and/or standards, such as IEEE 802.11, Code Division Multiplexing Access (CDMA), Wideband Code Division Multiple Access (WCDMA), GSM, LTE, New Radio (NR), UMTS, WiMax, Ethernet, transmission control protocol/internet protocol (TCP/IP), synchronous optical networking (SONET), Asynchronous Transfer Mode (ATM), QUIC, Hypertext Transfer Protocol (HTTP), and so forth.

Regardless of the type of sensor, a computer system may provide an output of data captured by its sensors, through its communication interface 712, via a wireless connection to a network node. Data captured by sensors of a computer system can be communicated through a wireless connection to a network node via another computer system. The output may be periodic (e.g., once every 15 minutes if it reports the sensed temperature), random (e.g., to even out the load from reporting from several sensors), in response to a triggering event (e.g., when moisture is detected an alert is sent), in response to a request (e.g., a user initiated request), or a continuous stream (e.g., a live video feed of a patient).

As another example, a computer system comprises an actuator, a motor, or a switch, related to a communication interface configured to receive wireless input from a network node via a wireless connection. In response to the received wireless input the states of the actuator, the motor, or the switch may change.

As yet another specific example, in an loT scenario, a computer system may represent a machine or other device that performs monitoring and/or measurements, and transmits the results of such monitoring and/or measurements to another computer system and/or a network node. The computer system may in this case be an M2M device, which may in a electrical switching 3GPP context be referred to as an MTC device. As one particular example, the computer system may implement the electrical switching 3GPP NB-loT standard.

In practice, any number of computer systems may be used together with respect to a single use case. The first and/or the second computer system can also include more than one of the functionalities described above. For example, a computer system might comprise the sensor and the actuator, and handle communication of data for both the speed sensor and the actuators.

Although the computing devices described herein (e.g., computer system) may include the illustrated combination of hardware components, other embodiments may comprise computing devices with different combinations of components. It is to be understood that these computing devices may comprise any suitable combination of hardware and/or software needed to perform the tasks, features, functions and methods disclosed herein. Determining, calculating, obtaining or similar operations described herein may be performed by processing circuitry, which may process information by, for example, converting the obtained information into other information, comparing the obtained information or converted information to information stored in the computer system, and/or performing one or more operations based on the obtained information or converted information, and as a result of said processing making a determination. Moreover, while components are depicted as single boxes located within a larger box, or nested within multiple boxes, in practice, computing devices may comprise multiple different physical components that make up a single illustrated component, and functionality may be partitioned between separate components. For example, a communication interface may be configured to include any of the components described herein, and/or the functionality of the components may be partitioned between the processing circuitry and the communication interface. In another example, non-computationally intensive functions of any of such components may be implemented in software or firmware and computationally intensive functions may be implemented in hardware.

In certain embodiments, some or all of the functionality described herein may be provided by processing circuitry executing instructions stored on in memory, which in certain embodiments may be a computer program product in the form of a non-transitory computer-readable storage medium. In alternative embodiments, some or all of the functionalities may be provided by the processing circuitry without executing instructions stored on a separate or discrete device-readable storage medium, such as in a hard-wired manner. In any of those particular embodiments, whether executing instructions stored on a non-transitory computer-readable storage medium or not, the processing circuitry can be configured to perform the described functionality. The benefits provided by such functionality are not limited to the processing circuitry alone or to other components of the computing device but are enjoyed by the computing device as a whole, and/or by end users.

## Claims

1. A computer-implemented method (M) for monitoring an electrical switching component (1) immersed in a liquid in a container (2) of an electric device (10) comprising a transformer or of an on-load tap changer (OLTC) (3), said method (M) comprising, by a processing circuitry (4) of a computer system (5):
obtaining (M1) a vibration signature model defining at least a vibration signature associated with movement of one or more mechanical components of the electrical switching component 1 during a switching sequence of the electrical switching component 1 from a one switching position to another switching position of the electrical switching component,
obtaining (M2) a vibration signal recording (R) from a vibration sensor (4) configured to measure vibrations of the container (2), and
determining (M3) a first smoothed curve (C1) based on the vibration signal recording (R) using a first smoothing level,
said method (M) being **characterized in that** it further comprises, by the processing circuitry (4) of the computer system (5):
determining (M4) a second smoothed curve (C2) based on the vibration signal recording (R) using a second smoothing level lower than the first smoothing level, wherein the use of a lower smoothing level means that more details of the vibration signal recording remain in the smoothed curve than would have been the case when using a higher smoothing level,
selecting (M5) a portion in time of the second smoothed curve (C2) based on an extent in time of a peak (P1) of the first smoothed curve (C1),
comparing (M6) one or more peaks (P2) of the selected portion the second smoothed curve (C2) to one or more peaks of a corresponding portion of the vibration signature to determine one or more deviations based on the comparison,
determining (M7) a deviation status based on the deviations, and
providing (M8) a deviation status signal based on the deviation status.

2. The computer-implemented method (M) according to claim 1,
wherein the extent in time of a peak of the first smoothed curve (C1) is from a start time of the peak (P1) of the first smoothed curve (C1) to a start time of a subsequent peak or, if no subsequent peak is present in the first smoothed curve (C1), to the end of the first smoothed curve (C1), or to a time being offset a predetermined time after the start time of the last peak (P1) of the first smoothed curve (C1).

3. The computer-implemented method (M) according to claim 2, wherein the start time is determined to be the time when the first smoothed curve (C1) reaches a minimum absolute value between the peak (P1) and a preceding peak of the first smoothed curve (C1), or reaches a predetermined threshold level (L), whichever occurs closer in time to the time of a maximum absolute value of the peak.

4. The computer-implemented method (M) according to any one of the preceding claims, wherein said comparing of one or more peaks of the selected portion the second smoothed curve (C2) to the one or more peaks of a corresponding portion of the vibration signature comprises comparing a maximum absolute value and/or a duration of one or more peaks of the selected portion of the second smoothed curve (C2) to a maximum absolute value and/or duration of one or more corresponding peaks of a corresponding portion of the vibration signature.

5. The computer-implemented method (M) according to claim 4, wherein the duration is calculated as the extent in time from a start time of a peak (P2) of the second smoothed curve (C2) to a start time of a subsequent peak of the second smoothed curve (C2), or, if no subsequent peak is present in the second smoothed curve (C2), to the end of the second smoothed curve (C2), or to a time being offset a predetermined time after the start time of the peak (P2).

6. The computer-implemented method (M) according to any one of the preceding claims, wherein the deviation status is determined to be a normal status in response to said deviation being within a predetermined deviation range or below a predetermined deviation threshold, and/or wherein the deviation status is determined to be an error status in response to said deviation being outside said predetermined deviation range or exceeding said predetermined deviation threshold.

7. The computer-implemented method (M) according to any one of the preceding claims, wherein a low-pass filter is applied to the vibration signal when determining the first and second smoothed curves.

8. The computer-implemented method (M) according to claim 7, wherein the low-pass filter has a cut-off frequency of 0.5 - 1 kHz.

9. The computer-implemented method (M) according to any one of the preceding claims, wherein the first smoothed curve is determined using a root mean square smoothing with a moving time window in the range of 5-10 milliseconds.

10. The computer-implemented method (M) according to claim 9, wherein the second smoothed curve is determined using a root mean square smoothing with a moving time window smaller than the moving time window used for determining the first smoothed curve.

11. An electrical device (10) comprising a transformer or an on-load tap changer (OLTC) (3), said electrical device (10) comprising:
a container (2),
an electrical switching component (1) immersed in a liquid in the container (2),
a vibration sensor (4) configured to measure vibrations of the container, and
a computer system (700) comprising a processing circuitry (702) configured to perform the computer-implemented method (M) according to any one of claims 1-10.

12. An electrical device (10) according to claim 11, wherein the vibration sensor (4) is attached to the container (2) or wherein the vibration sensor (4) is an optical sensor configured to measure vibration of the container (2) using light reflected by the container (2) to the optical sensor.

## Patentansprüche

1. Computerimplementiertes Verfahren (M) zum Überwachen einer elektrischen Schaltkomponente (1), die in eine Flüssigkeit in einem Behälter (2) einer elektrischen Vorrichtung (10), die einen Transformator umfasst, oder eines Laststufenschalters (OLTC) (3) eingetaucht ist, wobei das Verfahren (M) Folgendes durch eine Verarbeitungsschaltung (4) eines Computersystems (5) umfasst:
Erhalten (M1) eines Vibrationssignaturmodells, das mindestens eine Vibrationssignatur definiert, die mit einer Bewegung einer oder mehrerer mechanischer Komponenten der elektrischen Schaltkomponente 1 während einer Schaltsequenz der elektrischen Schaltkomponente 1 von einer Schaltposition in eine andere Schaltposition der elektrischen Schaltkomponente assoziiert ist,
Erhalten (M2) einer Vibrationssignalaufzeichnung (R) von einem Vibrationssensor (4), der dazu ausgelegt ist, Vibrationen des Behälters (2) zu messen, und
Bestimmen (M3) einer ersten geglätteten Kurve (C1) basierend auf der Vibrationssignalaufzeichnung (R) unter Verwendung eines ersten Glättungsgrads,
wobei das Verfahren (M) **dadurch gekennzeichnet ist, dass** es ferner Folgendes durch die Verarbeitungsschaltung (4) des Computersystems (5) umfasst:
Bestimmen (M4) einer zweiten geglätteten Kurve (C2) basierend auf der Vibrationssignalaufzeichnung (R) unter Verwendung eines zweiten Glättungsgrads, der niedriger als der erste Glättungsgrad ist, wobei die Verwendung eines niedrigeren Glättungsgrads bedeutet, dass mehr Details der Vibrationssignalaufzeichnung in der geglätteten Kurve verbleiben, als dies bei Verwendung eines höheren Glättungsgrads der Fall gewesen wäre,
Auswählen (M5) eines Zeitabschnitts der zweiten geglätteten Kurve (C2) basierend auf einer zeitlichen Ausdehnung einer Spitze (P1) der ersten geglätteten Kurve (C1),
Vergleichen (M6) einer oder mehrerer Spitzen (P2) des ausgewählten Abschnitts der zweiten geglätteten Kurve (C2) mit einer oder mehreren Spitzen eines entsprechenden Abschnitts der Vibrationssignatur, um basierend auf dem Vergleich eine oder mehrere Abweichungen zu bestimmen, Bestimmen (M7) eines Abweichungsstatus basierend auf den Abweichungen, und
Bereitstellen (M8) eines Abweichungsstatussignals basierend auf dem Abweichungsstatus.

2. Computerimplementiertes Verfahren (M) nach Anspruch 1, wobei die zeitliche Ausdehnung einer Spitze der ersten geglätteten Kurve (C1) von einer Startzeit der Spitze (P1) der ersten geglätteten Kurve (C1) bis zu einer Startzeit einer nachfolgenden Spitze oder, falls keine nachfolgende Spitze in der ersten geglätteten Kurve (C1) vorhanden ist, bis zum Ende der ersten geglätteten Kurve (C1) oder bis zu einer Zeit, die nach der Startzeit der letzten Spitze (P1) der ersten geglätteten Kurve (C1) um eine vorbestimmte Zeit versetzt ist, reicht.

3. Computerimplementiertes Verfahren (M) nach Anspruch 2, wobei bestimmt wird, dass die Startzeit die Zeit ist, zu der die erste geglättete Kurve (C1) einen minimalen Absolutwert zwischen der Spitze (P1) und einer vorhergehenden Spitze der ersten geglätteten Kurve (C1) erreicht oder einen vorbestimmten Schwellengrad (L) erreicht, je nachdem, was zeitlich näher zu der Zeit eines maximalen Absolutwerts der Spitze erfolgt.

4. Computerimplementiertes Verfahren (M) nach einem der vorhergehenden Ansprüche, wobei das Vergleichen einer oder mehrerer Spitzen des ausgewählten Abschnitts der zweiten geglätteten Kurve (C2) mit der einen oder den mehreren Spitzen eines entsprechenden Abschnitts der Vibrationssignatur Vergleichen eines maximalen Absolutwerts und/oder einer Dauer einer oder mehrerer Spitzen des ausgewählten Abschnitts der zweiten geglätteten Kurve (C2) mit einem maximalen Absolutwert und/oder einer Dauer einer oder mehrerer entsprechender Spitzen eines entsprechenden Abschnitts der Vibrationssignatur umfasst.

5. Computerimplementiertes Verfahren (M) nach Anspruch 4, wobei die Dauer als die zeitliche Ausdehnung von einer Startzeit einer Spitze (P2) der zweiten geglätteten Kurve (C2) bis zu einer Startzeit einer nachfolgenden Spitze der zweiten geglätteten Kurve (C2) oder, falls keine nachfolgende Spitze in der zweiten geglätteten Kurve (C2) vorhanden ist, bis zum Ende der zweiten geglätteten Kurve (C2) oder bis zu einer Zeit, die nach der Startzeit der Spitze (P2) um eine vorbestimmte Zeit versetzt ist, berechnet wird.

6. Computerimplementiertes Verfahren (M) nach einem der vorhergehenden Ansprüche, wobei als Reaktion darauf, dass die Abweichung innerhalb eines vorbestimmten Abweichungsbereichs oder unter einem vorbestimmten Abweichungsschwellenwert liegt, bestimmt wird, dass der Abweichungsstatus ein normaler Status ist, und/oder wobei als Reaktion darauf, dass die Abweichung außerhalb des vorbestimmten Abweichungsbereichs liegt oder den vorbestimmten Abweichungsschwellenwert überschreitet, bestimmt wird, dass der Abweichungsstatus ein Fehlerstatus ist.

7. Computerimplementiertes Verfahren (M) nach einem der vorhergehenden Ansprüche, wobei bei Bestimmen der ersten und der zweiten geglätteten Kurve ein Tiefpassfilter auf das Vibrationssignal angewendet wird.

8. Computerimplementiertes Verfahren (M) nach Anspruch 7, wobei das Tiefpassfilter eine Grenzfrequenz von 0,5-1 kHz aufweist.

9. Computerimplementiertes Verfahren (M) nach einem der vorhergehenden Ansprüche, wobei die erste geglättete Kurve unter Verwendung einer Glättung mit dem quadratischen Mittelwert mit einem sich bewegenden Zeitfenster im Bereich von 5-10 Millisekunden bestimmt wird.

10. Computerimplementiertes Verfahren (M) nach Anspruch 9, wobei die zweite geglättete Kurve unter Verwendung einer Glättung mit dem quadratischen Mittelwert mit einem sich bewegenden Zeitfenster bestimmt wird, das kleiner als das sich bewegende Zeitfenster ist, das zum Bestimmen der ersten geglätteten Kurve verwendet wird.

11. Elektrische Vorrichtung (10), die einen Transformator oder einen Laststufenschalter (OLTC) (3) umfasst, wobei die elektrische Vorrichtung (10) Folgendes umfasst:
einen Behälter (2),
eine elektrische Schaltkomponente (1), die in eine Flüssigkeit in dem Behälter (2) eingetaucht ist,
einen Vibrationssensor (4), der dazu ausgelegt ist, Vibrationen des Behälters zu messen, und
ein Computersystem (700), das eine Verarbeitungsschaltung (702) umfasst, die dazu ausgelegt ist, das computerimplementierte Verfahren (M) nach einem der Ansprüche 1-10 durchzuführen.

12. Elektrische Vorrichtung (10) nach Anspruch 11, wobei der Vibrationssensor (4) am Behälter (2) angebracht ist oder wobei der Vibrationssensor (4) ein optischer Sensor ist, der dazu ausgelegt ist, eine Vibration des Behälters (2) unter Verwendung von Licht zu messen, das von dem Behälter (2) zu dem optischen Sensor reflektiert wird.

## Revendications

1. Procédé mis en œuvre par ordinateur (M) pour surveiller un composant de commutation électrique (1) immergé dans un liquide dans un contenant (2) d'un dispositif électrique (10) comprenant un transformateur ou d'un graduateur de réglage en charge (OLTC) (3), ledit procédé (M) comprenant, par une circuiterie de traitement (4) d'un système informatique (5) :
l'obtention (M1) d'un modèle de signature de vibration définissant au moins une signature de vibration associée au déplacement d'un ou de plusieurs composants mécaniques du composant de commutation électrique 1 pendant une séquence de commutation du composant de commutation électrique 1 d'une position de commutation à une autre position de commutation du composant de commutation électrique,
l'obtention (M2) d'un enregistrement de signal de vibration (R) à partir d'un capteur de vibrations (4) configuré pour mesurer des vibrations du contenant (2), et
la détermination (M3) d'une première courbe lissée (C1) sur la base de l'enregistrement de signal de vibration (R) en utilisant un premier niveau de lissage,
ledit procédé (M) étant **caractérisé en ce qu'**il comprend en outre, par la circuiterie de traitement (4) du système informatique (5) :
la détermination (M4) d'une deuxième courbe lissée (C2) sur la base de l'enregistrement de signal de vibration (R) en utilisant d'un deuxième niveau de lissage plus bas que le premier niveau de lissage, dans lequel l'utilisation d'un niveau de lissage plus bas signifie que plus de détails de l'enregistrement de signal de vibration restent dans la courbe lissée que cela n'aurait été le cas lors de l'utilisation d'un niveau de lissage plus élevé,
la sélection (M5) d'une portion dans le temps de la deuxième courbe lissée (C2) sur la base d'une étendue dans le temps d'un pic (P1) de la première courbe lissée (C1),
la comparaison (M6) d'un ou de plusieurs pics (P2) de la portion sélectionnée de la deuxième courbe lissée (C2) à un ou plusieurs pics d'une portion correspondante de la signature de vibration pour déterminer un ou plusieurs écarts sur la base de la comparaison,
la détermination (M7) d'un état d'écart sur la base des écarts, et
la fourniture (M8) d'un signal d'état d'écart sur la base de l'état d'écart.

2. Procédé mis en œuvre par ordinateur (M) selon la revendication 1, dans lequel l'étendue dans le temps d'un pic de la première courbe lissée (C1) est à partir d'un temps de début du pic (P1) de la première courbe lissée (C1) jusqu'à un temps de début d'un pic subséquent ou, si aucun pic subséquent n'est présent dans la première courbe lissée (C1), jusqu'à la fin de la première courbe lissée (C1), ou jusqu'à un temps étant décalé d'un temps prédéterminé après le temps de début du dernier pic (P1) de la première courbe lissée (C1).

3. Procédé mis en œuvre par ordinateur (M) selon la revendication 2, dans lequel le temps de début est déterminé comme étant, entre le temps où la première courbe lissée (C1) atteint une valeur absolue minimale entre le pic (P1) et un pic précédent de la première courbe lissée (C1), ou atteint un niveau de seuil prédéterminé (L), celui qui se produit le plus près dans le temps du temps d'une valeur absolue maximale du pic.

4. Procédé mis en œuvre par ordinateur (M) selon l'une quelconque des revendications précédentes, dans lequel ladite comparaison d'un ou de plusieurs pics de la portion sélectionnée de la deuxième courbe lissée (C2) aux un ou plusieurs pics d'une portion correspondante de la signature de vibration comprend la comparaison d'une valeur absolue maximale et/ou d'une durée d'un ou de plusieurs pics de la portion sélectionnée de la deuxième courbe lissée (C2) à une valeur absolue maximale et/ou à une durée d'un ou de plusieurs pics correspondants d'une portion correspondante de la signature de vibration.

5. Procédé mis en œuvre par ordinateur (M) selon la revendication 4, dans lequel la durée est calculée comme l'étendue dans le temps à partir d'un temps de début d'un pic (P2) de la deuxième courbe lissée (C2) jusqu'à un temps de début d'un pic subséquent de la deuxième courbe lissée (C2), ou, si aucun pic subséquent n'est présent dans la deuxième courbe lissée (C2), jusqu'à la fin de la deuxième courbe lissée (C2), ou jusqu'à un temps étant décalé d'un temps prédéterminé après le temps de début du pic (P2).

6. Procédé mis en œuvre par ordinateur (M) selon l'une quelconque des revendications précédentes, dans lequel l'état d'écart est déterminé comme étant un état normal en réponse audit écart étant à l'intérieur d'une plage d'écart prédéterminée ou inférieure à un seuil d'écart prédéterminé, et/ou dans lequel l'état d'écart est déterminé comme étant un état d'erreur en réponse au fait que ledit écart est en dehors de ladite plage d'écart prédéterminée ou dépasse ledit seuil d'écart prédéterminé.

7. Procédé mis en œuvre par ordinateur (M) selon l'une quelconque des revendications précédentes, dans lequel un filtre passe-bas est appliqué au signal de vibration lors de la détermination des première et deuxième courbes lissées.

8. Procédé mis en œuvre par ordinateur (M) selon la revendication 7, dans lequel le filtre passe-bas a une fréquence de coupure de 0,5 à 1 kHz.

9. Procédé mis en œuvre par ordinateur (M) selon l'une quelconque des revendications précédentes, dans lequel la première courbe lissée est déterminée en utilisant un lissage carré moyen racine avec une fenêtre temporelle mobile dans la plage de 5 à 10 millisecondes.

10. Procédé mis en œuvre par ordinateur (M) selon la revendication 9, dans lequel la deuxième courbe lissée est déterminée en utilisant un lissage carré moyen racine avec une fenêtre temporelle mobile plus petite que la fenêtre temporelle mobile utilisée pour déterminer la première courbe lissée.

11. Dispositif électrique (10) comprenant un transformateur ou un graduateur de réglage en charge (OLTC) (3), ledit dispositif électrique (10) comprenant :
un contenant (2),
un composant de commutation électrique (1) immergé dans un liquide dans le contenant (2),
un capteur de vibrations (4) configuré pour mesurer des vibrations du contenant, et
un système informatique (700) comprenant une circuiterie de traitement (702) configurée pour réaliser le procédé mis en œuvre par ordinateur (M) selon l'une quelconque des revendications 1 à 10.

12. Dispositif électrique (10) selon la revendication 11, dans lequel le capteur de vibrations (4) est attaché au contenant (2) ou dans lequel le capteur de vibrations (4) est un capteur optique configuré pour mesurer la vibration du contenant (2) en utilisant la lumière réfléchie par le contenant (2) vers le capteur optique.
